# FASCICULE DE BREVET EUROPEEN

(11) **EP 1 908 114 B1**
(45) Date de publication et mention de la délivrance du brevet: **30.12.2015**
(21) Numéro de dépôt: 06778883.6
(22) Date de dépôt: 18.07.2006
(51) Int. Cl.: H01L 29/737, H01L 21/331, H01L 29/201

(54) **PROCEDE DE REALISATION D'UN TRANSISTOR BIPOLAIRE A HETEROJONCTION**
VERFAHREN ZUM HERSTELLEN EINES HETEROÜBERGANGS-BIPOLARTRANSISTORS
METHOD FOR MAKING A HETEROJUNCTION BIPOLAR TRANSISTOR

(30) Priorité: 18.07.2005 FR 0507605
(43) Date de publication de la demande: 09.04.2008
(73) Titulaire: CENTRE NATIONAL DE LA RECHERCHE SCIENTIFIQUE -CNRS-, 75794 Paris Cedex 16 (FR); Soitec, 38190 Bernin (FR)
(72) Inventeur: PELOUARD, Jean-Luc, F-75020 PARIS (FR); LIJADI, Melania, F-92260 Fontenay aux Roses (FR); DUPUIS, Christophe, F-94240 L'Hay les Roses (FR); PARDO, Fabrice, F-94400 Vitry sur Seine (FR); BOVE, Philippe, F-91190 Gif sur Yvette (FR)
(74) Mandataire: Novagraaf Technologies
(86) Numéro de dépôt international: PCT/FR2006/001760
(87) Numéro de publication internationale: WO 2007/010135

(56) Documents cités:
- US-A- 6 165 859
- US-A1- 2004 214 401
- US-A1- 2004 227 155

## Description

La présente invention concerne un procédé de réalisation d'un transistor bipolaire à hétérojonction par empilement de couches semi-conductrices épitaxiées, et plus particulièrement un tel procédé comprenant les étapes consistant à épitaxier à partir d'un support au moins une couche de collecteur (pour une configuration E-up), respectivement d'émetteur (pour une configuration C-up), au moins une couche de base, et au moins une couche d'émetteur, respectivement de collecteur.

Un transistor bipolaire à hétérojonction est composé par l'empilement de trois régions semiconductrices, émetteur, base et collecteur, où l'émetteur présente une largeur de bande interdite supérieure à celle de la base. Son extension latérale (dans chacun des plans des régions précédentes) est composée de deux zones : l'une, dite intrinsèque ou active, est définie par la surface de la jonction émetteur-base; l'autre, dite extrinsèque ou parasite, se situe à la périphérie de la première, entre celle-ci et les contacts électriques (base et collecteur) du transistor. L'optimisation de la rapidité du TBH se fait en réduisant de façon conjointe, d'une part le temps de transit des porteurs entre l'émetteur et le collecteur et d'autre part les effets parasites (capacités et résistances série) associés à la zone extrinsèque.

La réduction du temps dé transit peut être obtenue par plusieurs approches, largement décrites dans la littérature : injection balistique dans la base (hétérojonction abrupte de type I), base fine, gradient de dopage et/ou de concentration dans la base (quasi-champ électrique), collecteur fin, injection balistique dans le collecteur (hétérojonction abrupte de type II), collecteur Schottky...

La réduction des effets parasites est, d'une manière générale, obtenue par la réduction de la largeur de la zone périphérique et par l'utilisation de matériaux appropriés (i.e. faible résistivité pour les résistances d'accès, faible permittivité électrique pour les capacités). La présente invention permet la réduction de la capacité base-collecteur avec la réduction du temps de transit décrite plus haut.

L'invention permet en effet de réaliser des TBH, notamment à couche de base en GaAsSb, ayant à la fois une base fine et contrainte et une jonction base-collecteur profondément sous-gravée. Ces deux points, jusqu'ici incompatibles dans un même transistor, permettent une amélioration notable de ses performances dynamiques. Le premier agit principalement sur les conditions du transport électronique (discontinuité de bande à l'interface émetteur-base, masse effective des porteurs, résistivité de la base, résistivité du contact de base...) alors que le second permet une réduction drastique de la capacité parasite base-collecteur (i.e. associée à la partie extrinsèque de la jonction base-collecteur), la capacité parasite limitant la fréquence de fonctionnement du TBH.

On connaît les TBH GaAsSb par le document *"*Ultra-high performante staggered lineup (« Type-II ») InP/GaAsSb/InP npn Double Heterojonction Bipolar Transistor" C.R.Bolognesi, M.W.Dvorak, N.Matine, O.J.Pitts et S.P.Watkins, Jpn. J. Appl. Phys. Vol.41 Part 1(2B) 1131 (2002). Ces transistors ont montré des résultats remarquables (f_{T}=fₘₐₓ=300 GHz), en net progrès par rapport à l'état de l'art de l'époque obtenu avec des structures InP/InGaAs. Les mêmes auteurs ont montré que la composition d'antimoine utilisée dans la couche de base était sensiblement inférieure à la concentration donnant l'accord de maille avec InP ([Sb]=0,5). La technologie employée a limité la sous-gravure de la couche collecteur à 750 nm sous le contact de base alors que ce dernier déborde de 1,5 µm du doigt d'émetteur. La confrontation des résultats expérimentaux à ceux issus de la simulation laisse envisager des performances nettement supérieures (i.e. > 500 GHz) pour un rapport unité des aires des jonctions émetteur-base et base-collecteur. Enfin l'apport du GaAsSb à la rapidité du transistor a été clairement établi.

Le document *"*InP/InGaAs SHBTs with 75 nm collector and fT > 500 GHz" W.Hafez, Jie-Wei Lai, et M.Feng, Electron. Lett. 39(20) (2003) décrit par ailleurs un empilement InP/InGaAs permettant d'obtenir des fréquences supérieures à 500 GHz. Ces résultats ont démontré importance de réduire à la fois les temps de transit des électrons en réduisant l'épaisseur des différentes couches semiconductrices (en particulier la couche de collecteur) et les dimensions latérales du composant.

Un TBH GaAsSb possède typiquement la structure montrée au tableau 1 ci-après.

Au cours de la fabrication du transistor, la couche d'InP du collecteur est gravée latéralement sur une forte profondeur de façon à réduire la capacité base-collecteur. Cette gravure ne peut se faire que par voie chimique car il n'existe pas de gravure sèche assez anisotrope pour cet usage. On utilise la très forte sélectivité de la gravure chimique d'InP par rapport aux arséniures (ici GaAsSb et InGaAs) dans, par exemple, une solution H₃PO₄:HCl.

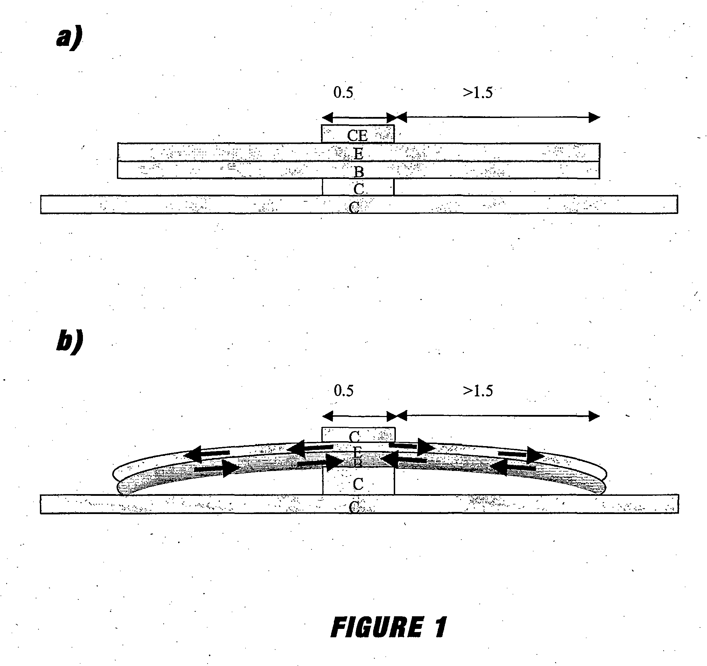

La base étant très fine (typiquement entre 20 et 50 nm), elle ne présente pas une rigidité suffisante pour s'auto-porter sur une aussi grande longueur (typiquement 1,5 à 2 µm). Le procédé de fabrication connu prévoit donc de préserver la couche d'émetteur E aux mêmes cotes que celles de la base B pendant la sous-gravure de la couche d'InP située dans le collecteur C (figure 1a).

A cet état d'avancement du procédé, la structure connue jusqu'à maintenant présente un grave défaut dans le cas de base en GaAsSb ayant un taux d'antimoine inférieur à 50%. En effet, l'émetteur (InP ou InGaAlAs) devant impérativement être épitaxié à l'accord de maille avec InP, il existe un important écart de paramètre cristallin. (défaut d'accord de maille) entre les deux couches constituant le surplomb de base (E et B figure 1 a) en surplomb de la sous-gravure d'InP. Sous l'action de cette contrainte, ce surplomb se déforme (figure 1 b) pouvant créer un court-circuit entre la base et le collecteur et rendant en tout état de cause difficile l'introduction de résine entre la couche de base et la couche de contact collecteur CC.

Pour ces raisons, l'homme de l'art se limite généralement à graver uniquement des empilements réalisés avec des matériaux à l'accord de maille entre eux, c'est-à-dire des empilements qui ne présentent aucune contrainte.

C'est cet inconvénient que la présente invention se propose de pallier en introduisant une nouvelle couche de quaternaire InGaAlAs dans le collecteur. La symétrie (même approximative) de l'empilement des couches dans le surplomb de base équilibre les contraintes et réduit très fortement les déformations.

Par ailleurs, il est connu de modifier la composition du semi-conducteur pour réaliser la couche de base, de sorte à modifier de manière importante les propriétés du transport électronique dans la zone active du transistor.

L'invention assure la compatibilité entre la réalisation d'une sous-gravure profonde et l'existence d'une contrainte dans la couche de base.

L'invention a également pour but de rendre possible l'utilisation dans un TBH, d'une base constituée d'un alliage semi-conducteur dont l'arrangement moléculaire (dépendant de la composition de l'alliage) ne correspond pas à l'accord de maille requis par la couche d'émetteur ou de collecteur. Par exemple, l'invention permet l'utilisation d'une base en alliage GaAsSb avec un taux d'antimoine supérieur ou inférieur à 50 %.

On connaît de l'art antérieur la demande de brevet américain US-2004/0227155 A1 qui propose d'introduire entre la couche de base et la couche de collecteur une sous-couche en In Ga As Sb de sorte à améliorer les qualités du TBH. Le TBH ainsi réalisé ne présente aucune contrainte liée à un défaut d'accord de maille, même avant introduction de la sous-couche.

On connaît également la demande de brevet US-2004/0214401 A1 qui décrit un procédé de passivation d'un TBH par épitaxie d'un semi-conducteur sur toute sa surface. US 6165 859 décrit un transistor bipolaire à hétérojonction.

Enfin, on connaît le document de brevet US-6 165 859 qui décrit la réalisation de contacts faiblement résistifs en Pd/Pt/Au.

L'invention a tout d'abord pour objet un procédé de réalisation d'un transistor bipolaire à hétérojonction selon la revendication 1.

L'invention a également pour objet un transistor dipolaire à hétérojonction selon la revendication 2.

Selon l'invention, ladite couche de collecteur, respectivement d'émetteur, comprend :
au moins une première sous-couche au contact de ladite couche de base, d'équilibre des contraintes dues à ladite couche d'émetteur, respectivement de collecteur, notamment une sous-couche sensiblement de même composition que ladite couche d'émetteur, respectivement de collecteur ; et
- au moins une deuxième sous-couche du côté opposé à ladite couche de base par rapport à ladite première sous-couche.

Optimalement, cette extension latérale serait de l'ordre de celle de la jonction émetteur-base, respectivement collecteur-base. En pratique toutefois elle sera légèrement supérieure, mais bien entendu inférieure à celle de la base.

Dans un mode de mise en oeuvre particulier, pour la réalisation d'un transistor comportant une couche de contact émetteur, respectivement collecteur, et un contact métallique, ce procédé comprend l'étape consistant à encapsuler ledit contact émetteur, respectivement collecteur, et le contact métallique dans un matériau de protection contre la gravure.

Dans un mode de réalisation particulier, l'étape d'encapsulation comprend l'encapsulation de la partie non gravée de la deuxième sous-couche d'émetteur, respectivement de collecteur, située entre la première sous-couche d'émetteur, respectivement de collecteur et la couche de contact émetteur, respectivement collecteur.

L'invention a également pour objet un transistor tel que décrit ci-dessus, dans lequel :
- ladite couche de base est en GaAsSb ;
- lesdites premières sous-couches sont en InGaAIAs ; et
- lesdites deuxièmes sous-couches sont en InP.

Enfin, l'invention vise une utilisation de sous-couches d'équilibre de contraintes générées par des couches épitaxiées qui sont empilées les unes sur les autres, l'emplilement présentant des défauts d'accords de mailles entre les couches épitaxiées de par leur composition, et notamment de par la composition de la couche de base.

On décrira maintenant, à titre d'exemple non limitatif, un mode de fabrication d'un transistor particulier conforme à l'invention, en référence aux dessins schématiques annexés dans lesquels :
- la figure 1 illustre l'état de la technique, les dimensions qui y sont données (en µm) ne l'étant qu'à titre indicatif ;
- la figure 2 illustre les étapes du procédé de réalisation des contacts métalliques ;
- la figure 3 montre l'évolution de la forme du contact au cours de l'étape représentée à la figure 2 f) ;
- la figure 4 illustre les étapes de gravure des couches semiconductrices.

On décrira ici le procédé dans une application à la fabrication de transistors bipolaires à hétérojonctiôn (TBH) ultrarapides (f > 500 GHz), mais il peut être appliqué dans le cadre de la réalisation d'autres dispositifs.

Le procédé d'ensemble comprend essentiellement trois groupes d'étapes : la réalisation de l'empilement épitaxié, la réalisation des contacts métalliques et la gravure des couches semiconductrices.

### Réalisation de l'empilement épitaxié

Les premières étapes du procédé selon l'invention, décrite ici dans le cadre d'une configuration E-up (émetteur sur le dessus), consistent à épitaxier de façon connue en soi, les matériaux semiconducteurs utilisés pour la réalisation du TBH. Ces étapes sont mises en oeuvre couche par couche sur un substrat (ici InP) qui impose à l'ensemble de la structure sa maille cristalline. Un exemple des caractéristiques des différentes couches est donné dans le tableau ci-après :

**Tableau 1**

| **Couche** | **Matériau** | **Dopage typ. (cm-3)** | **Epaisseur typ. (nm)** |
|---|---|---|---|
| **CE** contact émet. | InGaAs | >1x10¹⁹ | 100 |
| **E2** émetteur 2 | InP | >1x10¹⁹ | 50 |
| **E1** émetteur 1 | InGaAIAs | 3-10 x10¹⁷ | 30 à 70 |
| **B** base | GaAsSb | >5x10¹⁹ | 20 à 50 |
| **C1** collecteur 1 | InGaAIAs | 5x10¹⁶ | 50 à 100 |
| **C2** collecteur 2 | InP | 5x10¹⁹ | 100 à 200 |
| **C3** etch-stop coll. | InGaAs | >1x10¹⁹ | 10 à 50 |
| **C4** etch-stop coll. | InP | >1x10¹⁹ | 10 à 50 |
| **C5** contact coll. | InGaAs | >1x10¹⁹ | 10 à 50 |

On ne décrira ci-après en détail que les couches situées au voisinage de la couche de base.

La couche de base est réalisée en GaAsSb. Elle est très fortement dopée de type p au carbone (>5x10¹⁹ cm⁻³). Son épaisseur dépend du niveau de dopage choisi, elle peut varier ici entre 20 et 50nm. Son taux d'antimoine est quelconque (typiquement compris entre 25 et 75%). Le taux d'antimoine, comme le niveau de dopage peut présenter un gradient pour réduire le temps de transit des électrons dans la base.

GaAsSb est un matériau particulièrement adapté pour les raisons suivantes :
- Il présente avec les matériaux à large bande interdite disponibles sur substrat InP une discontinuité dans la bande de valence (0,79 eV avec InP, 0,63 eV avec InAlAs) très grande devant k_{B}T qui rend, quelque soient le niveau de dopage de la base et le matériau utilisé dans l'émetteur, le courant de trous injectés dans l'émetteur négligeable devant celui porté par les électrons injectés dans la base.
- Il peut présenter un très fort niveau de dopage de type p en substituant aux atomes de site V des atomes de carbone. La limite de dopage au carbone est supérieure à 2x10²⁰ cm⁻³. Dans cette gamme de dopage, la mobilité des trous, mesurée par effet Hall, est constante. Toute augmentation de dopage se traduit donc par la même augmentation de conductivité électrique de la couche de base. Le coefficient de diffusion du carbone dans GaAsSb étant très faible, les profils de dopage après épitaxie sont abrupts et les effets de vieillissement du transistor observés pour d'autres dopants (p.ex. béryllium) sont considérés comme négligeables.
- Il présente avec l'alliage quaternaire InGaAIAs une discontinuité dans la bande de conduction qui est positive (i.e. de type I) lorsque le taux d'aluminium (concentration relative à l'ensemble des sites III) est supérieur à 38,5% et négative (i.e de type II) dans le cas, inverse. Ceci introduit une grande souplesse dans la conception de la structure.
- Il présente un piégeage du niveau de Fermi en surface situé dans la bande interdite à 0,22 eV de la bande de valence, ce qui a deux conséquences majeures pour le TBH : d'une part la résistivité spécifique des contacts ohmiques pris sur cette couche (contact de base) est très faible (ρ_{c}< 10⁻⁶ Ωcm²), d'autre part les vitesses de recombinaison de surface (recombinaison à la surface de la base extrinsèque) sont négligeables.
- Il présente une très forte adaptabitité à la maille cristalline que lui impose la couche semiconductrice sous-jacente. Cette propriété due à la présence d'antimoine, permet d'épitaxier sur des semiconducteurs en accord de maille avec InP, une couche de GaAsSb dont le taux d'antimoine peut varier dans une très large proportion. On a démontré un effet transistor dans des TBH ayant un taux d'antimoine dans la base en GaAsSb aussi varié que 50% (accord de maille avec InP), 25% (en tension sur InP) et 75% (en compression sur InP). Cette très grande flexibilité (unique dans l'ensemble des semiconducteurs III-V) ouvre de larges possibilités par la modification de paramètres cristallins fondamentaux (masse effective, les discontinuités de bandes, les durées de vie...) qui ont un impact fort sur les performances du TBH. En particulier, pour chacune des propriétés citées plus haut, il existe une concentration pour laquelle l'effet est optimal.

La couche d'émetteur, adjacente à la couche de base, est réalisée en InP ou en alliage quaternaire InGaAIAs, ou encore comme ici, sous la forme de deux sous-couches, à savoir une première sous-couche en alliage quaternaire InGaAIAs au contact de la couche de base et une deuxième sous-couche en InP à l'opposé de la couche de base par rapport à la première sous-couche. On choisit préférentiellement un quaternaire InGaAIAs dont le taux d'aluminium est supérieur à 38.5% (p.ex. InAlAs) de façon à créer une injection balistique d'électrons dans la base. Son niveau de dopage est choisi entre 3 et 10x10¹⁷ cm⁻³. Son épaisseur peut varier dans une fourchette assez large, avec une valeur typique d'environ 30 à 70 nm.

La couche de collecteur est composée de deux matériaux. La première sous-couche adjacente à la base est réalisée en alliage quaternaire InGaAIAs. Son taux d'aluminium est inférieur à 38,5% pour éviter les problèmes liés à la collection sélective des hétérojonctions de type I. On choisit préférentiellement un taux d'aluminium proche de 25 - 30% de façon à créer une injection balistique d'électrons dans la jonction base-collecteur (AEc compris entre 90 et 150 meV). Son niveau de dopage (typiquement 5x10¹⁶ cm⁻³) est choisi tel que la densité de courant au seuil de l'effet Kirk est supérieure à la densité de courant collecteur nécessaire pour atteindre les fréquences souhaitées. Son épaisseur (typiquement entre 50 et 100 nm) est le résultat d'un compromis entre rapidité du transistor (faible épaisseur donc faible temps de transit) et tenue mécanique du surplomb de base ainsi que la tenue en tension du transistor.

La deuxième sous-couche de la couche collecteur est réalisée en InP. C'est cette partie qui, comme on le verra ci-après est fortement sous-gravée (gravure chimique sélective) pour réduire la capacité base-collecteur du TBH. Elle est fortement dopée de type n (typiquement 1x10¹⁹ cm⁻³). Son Epaisseur (typiquement entre 100 et 200 nm) est suffisante pour assurer de bonnes conditions à la gravure chimique.

Les autres couches de l'empilement comprennent, entre le substrat et la deuxième sous-couche de collecteur, une couche de contact collecteur en InGaAs; et une première et une deuxième couche d'arrêt de gravure (etch-stop) respectivement en InP et en InGaAs, et au-dessus de la deuxième sous-couche d'émetteur, une couche de contact d'émetteur.

### Réalisation des contacts métalliques

Les étapes suivantes du procédé consistent à réaliser le contact métallique sur la couche de contact émetteur.

Une couche de tungstène est tout d'abord uniformément déposée sur la surface de l'empilement des couches épitaxiées dans lesquelles seront gravés les TBH ultérieurement (ou tout autre empilement de couche semiconductrices). Le tungstène est choisi pour un ensemble de raisons :
- Il forme un contact ohmique de faible résistivité spécifique avec le semiconducteur très fortement dopé de type n (typiquement InGaAs) situé au sommet de l'empilement du TBH dans les configurations E-up ou C-up.
- Il forme un excellent contact Schottky (i.e. faible courant de fuite) avec le semiconducteur faiblement dopé de type n situé au sommet de l'empilement du TBH dans la configuration C-up.
- Son caractère réfractaire assure une très bonne tenue aux élévations de température. Il peut donc supporter sans dommage, ni pour lui ni pour le semiconducteur sous-jacent, les différents recuits inhérents au procédé de fabrication du transistor (y compris une éventuelle implantation ionique et son recuit à haute température (>700°C)).
- Son très faible coefficient de diffusion dans les semiconducteurs en fait un candidat de choix pour améliorer la fiabilité du composant donc son impact industriel. Le même procédé peut être utilisé avec une couche de siliciure de tungstène WSi, matériau largement utilisé dans l'industrie du silicium pour sa conductivité électrique supérieure à celle du tungstène.

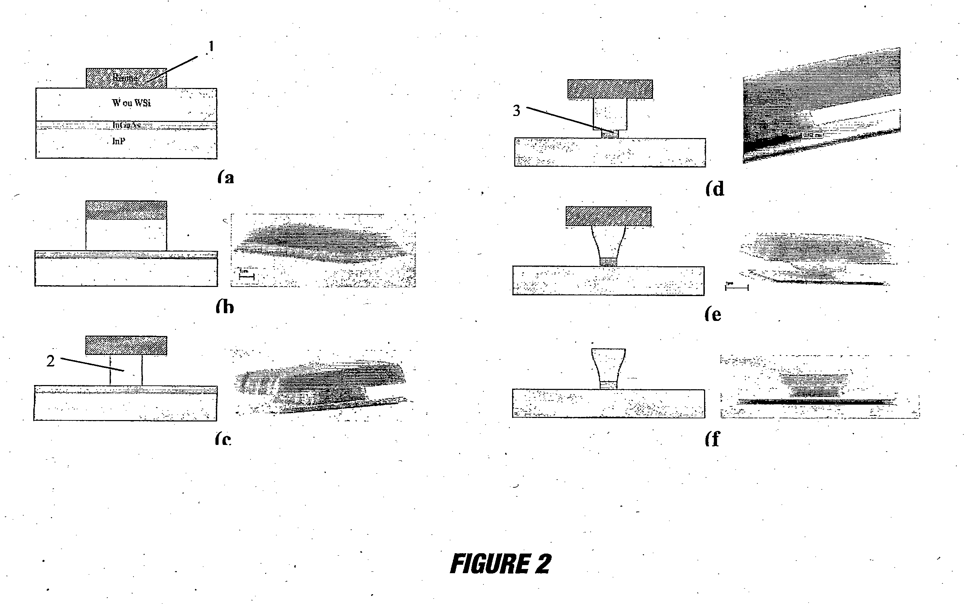

Un masque 1 est réalisé à la surface du tungstène par un des nombreux procédés connus de la technologie des semiconducteurs (figure 2a). On peut par exemple utiliser un masque de résine photosensible dont la forme est définie par photolithographie UV. Le choix du matériau constituant le masque est en fait très large (résine électro-sensible, de nombreux métaux ou diélectriques) puisqu'il suffit qu'il soit résistant aux deux solutions chimiques (dans le cas du présent exemple) qui seront utilisées par la suite pour graver le tungstène d'une part et le semiconducteur d'autre part. Ce point facilite l'insertion de ce procédé dans la chaîne de fabrication complexe des dispositifs.

Une première gravure de la couche de tungstène transfère la géométrie du masque dans la couche de tungstène (figure 2b). On utilise une gravure sèche réactive (ions fluor) qui permet d'obtenir des flancs présentant une faible inclinaison par rapport à la normale à la surface. Ensuite une sous-gravure par voie chimique sélective (solution connue à base de KOH) de la couche de tungstène est réalisée pour définir une première ébauche 2 de sa forme (figure 2c).

Cette ébauche est "généralement cylindrique", mais dans tous les cas les flancs du tungstène issus de ces gravures sont légèrement sortants. On peut supposer qu'une optimisation poussée des procédées de gravure sèche réactive (RIE) et chimiques pourrait conduire à des flancs quasi-verticaux, en aucun cas ils ne conduiraient à des flancs rentrants. Ces flancs sortants sont incompatibles avec une technologie auto-alignée, nécessaire à la réalisation des TBH, ultrarapides. En effet ce profil conduirait, au moment des dépôts métalliques constituant soit les contacts ohmiques de base et de collecteur, soit les ponts de sortie de contact, à la réalisation de courts-circuits entre l'émetteur et la base.

L'étape suivante consiste à graver puis sous-graver par voie chimique sélective la première couche 3 de semiconducteur de l'empilement épitaxié (figure 2d). Ceci introduit une contrainte dans la conception de l'empilement de ces couches. Dans le cas du TBH de la filière InP, cette contrainte est très faible puisque la couche de contact est toujours réalisée en InGaAs (pour la très faible résistivité du contact ohmique qui peut y être réalisé). Il s'agit ensuite de placer sous la couche d'InGaAs, une couche semiconductrice qui, sans nuire aux propriétés électriques du composant, servira de couche d'arrêt à la gravure chimique. D'autre part cette dernière couche doit être choisie parmi les semiconducteurs à large bande interdite (principe du TBH) en accord de maille avec les autres couches semiconductrices. Pour chacun de ces semiconducteurs (InP, InGaAIAs, InGaAsP dans la filière InP, ou AlGaAs, InGaP dans la filière GaAs) des solutions chimiques sont connues pour graver très préférentiellement InGaAs par rapport à ces matériaux.

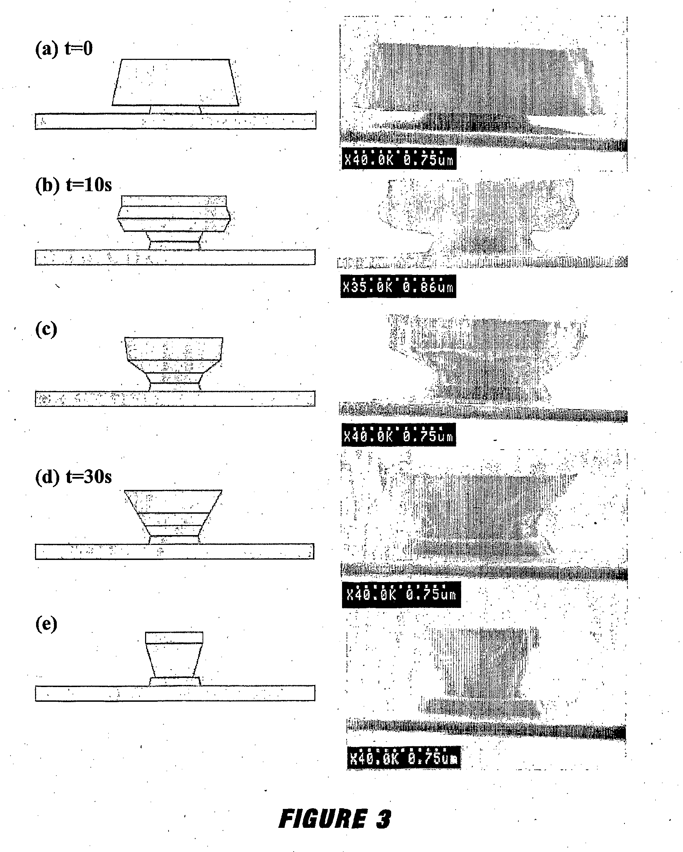

L'étape suivante consiste à graver chimiquement le flanc de la couche de tungstène pour obtenir le profil et les cotes désirés (figure 2e). L'existence de la sous-gravure de la couche d'InGaAs permet à la solution chimique de graver le tungstène sur sa face inférieure. C'est la gravure conjointe de la face inférieure et du flanc qui vont permettre d'obtenir le profil souhaité. Une fois l'épaisseur de la couche de tungstène fixée (par exemple 400 ou 600nm d'épaisseur) les cotes du profil sont obtenues par un contrôle du temps de gravure (figure 3). La qualité de ce contrôle est alors subordonnée à la vitesse de gravure de la solution chimique utilisée ainsi qu'à la rugosité du flanc de tungstène après gravure.

On observera que le procédé qui vient d'être décrit de réalisation du contact métallique d'émetteur (ou de collecteur dans la configuration C-up), dans le cadre de l'empilement épitaxié particulier décrit plus haut, pourrait très bien s'appliquer à un empilement traditionnel du type :

**Tableau 2**

| **Couche** | **Matériau** | **Dopage typ. (cm-3)** | **Epaisseur typ. (nm)** |
|---|---|---|---|
| **CE** contact émet. | InGaAs | 1x10¹⁹ | 100 |
| **E** émetteur | InGaAIAs | 3x10¹⁷ | 50 |
| **B** base | GaAsSb | 5x10¹⁹ | 20 à 50 |
| **C** collecteur | InP | 5x10¹⁶ | 100 |
| **CC** contact coll. | InGaAs | 1x10¹⁹ | 50 |

**Le procédé qui vient d'être décrit pourrait encore s'appliquer à l'empilement suivant :**

**Tableau 3**

| **Couche** | **Composition** | **Dopage (cm⁻³)** | **Epaisseur nm** | **Remarques** |
|---|---|---|---|---|
| Contact | InGaAs :Si | >1x10¹⁹ | 20 | |
| Emetteur | InGaAIAs :Si | 3x10¹⁷ | 50 | [Al] = 0,35 pauvre en In |
| Base | GaAsSb :C | 8x10¹⁹ | 35 | [Sb] = 0,39 |
| Collecteur 1 | InGaAIAs :Si | 5x10¹⁶ | 60 | [Al] = 0,25 Riche en In |
| Collecteur 2 | InP :Si | 5x10¹⁶ | 100 | |
| Sub-collecteur | InP :Si | 1x10¹⁹ | 200 | |
| Contact coll. | InGaAs :Si | 1x10¹⁹ | 30 | |
| Amortisseur | - | nid | - | |
| Substrat | InP :Fe (Si) | - | - | |

### Gravure des couches semiconductrices

Les dimensions de la base extrinsèque sont définies suivant tout procédé connu. La réalisation du transistor se poursuit par les étapes suivantes.

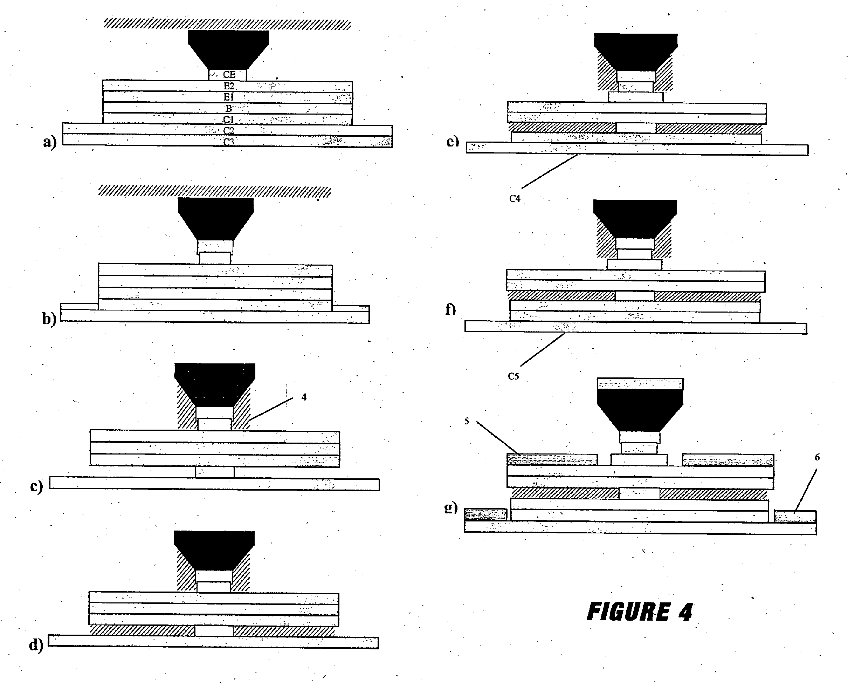

On grave la couche E2 d'InP de l'émetteur (figure 4b). On utilise la solution chimique H₃PO₄:HCl qui présente une très forte sélectivité avec les autres semiconducteurs de la structure. La couche C2 d'InP du collecteur est également partiellement gravée (la couche C2 a été choisie plus épaisse que la couche E2).

On réalise, à l'aide d'une résine photosensible, une encapsulation latérale 4 de protection des parties restantes de la couche de contact émetteur CE et de la couche E2, ainsi que du contact métallique. On notera que cette encapsulation est rendue plus facile par la présence du surplomb dans le contact émetteur, ici réalisé en tungstène.

On réalise une sous-gravure profonde de la couche C2 d'InP du collecteur (figure 4c). On utilise la solution chimique H₃PO₄:HCl qui présente une très forte sélectivité avec les autres semiconducteurs de la structure. Les autres couches ne sont donc pas gravées, en particulier les deux couches adjacentes : celle en alliage quaternaire, C1, et celle en InGaAs, C3. La couche E2 d'InP de l'émetteur est protégée par l'encapsulation latérale de résine photosensible.

On réalise ensuite une encapsulation de la sous-gravure profonde (figure 4d). La cavité réalisée sous le surplomb de base est emplie d'un matériau qui présente à la fois une viscosité suffisamment faible pour emplir la cavité, une bonne adhérence aux surfaces semiconductrices et la possibilité d'être durci une fois en place pour augmenter la tenue mécanique du surplomb, de base. On utilise par exemple une résine photosensible qui est ensuite polymérisée par un recuit à 170°C pendant une heure. D'autres matériaux sont également disponible dans le commerce : polyimide, BCB...

Son grave la couche E1 d'InGaAIAs de l'émetteur (figure 4e). Cette couche fait partie intégrante de l'émetteur (type n). Elle doit être retirée pour pouvoir déposer le contact ohmique sur la base. On utilise une solution chimique (p.ex. acide citrique : H₂O₂) qui grave sélectivement l'alliage quaternaire InGaAIAs par rapport à GaAsSb (la couche de base doit garder son épaisseur initiale pour ne pas augmenter la résistance d'accès à la base). La couche C3 stop-etch en InGaAs du collecteur est également gravée durant cette gravure. La couche C4 stop-etch en InP du collecteur n'est pas gravée. La gravure latérale de la couche E1 peut être minimisée de façon que le doigt d'émetteur soit plus large au niveau de la couche E1 que de la couche E2. Dans ces conditions, l'excédent de largeur de la couche E1 est entièrement déplété de porteur, de sorte qu'il a une action de réduction des recombinaisons des électrons minoritaires à la surface de la base extrinsèque.

On grave la couche C4 stop-etch en InP du collecteur (figure 4f) pour découvrir la couche C5 de contact collecteur où sera déposé le contact ohmique collecteur. On utilise la solution chimique H₃PO₄:HCl qui présente une très forte sélectivité avec les autres semiconducteurs de la structure (les autres couches en InP étant protégées).

On isole électriquement les transistors par une gravure profonde des couches C5 et sous-jacentes (non représenté).

On dépose les contacts ohmiques (figure 3.g). Les surplombs présents entre l'émetteur et la base (dû à la forme tronconique du contact) d'une part et entre la base et le collecteur d'autre part sont mis à profit pour réaliser les contacts de base 5 et de collecteur 6 en une seule fois (dans le cas de l'émetteur, il s'agit d'un épaississement du contact en tungstène). Cet auto-alignement permet de réduire de façon contrôlée la distance entre le contact de base et la zone active du transistor (typiquement entre 100 et 200 nm). Le dépôt métallique est optimisé pour réduire la résistance de contact sur la couche de GaAsSb. On peut utiliser à cet effet un empilement Pt/Ti/Pt/Au.

A ce stade le transistor est terminé. Il sera par la suite relié électriquement aux sorties de contact ou aux autres composants du circuit.

Le procédé qui vient d'être décrit met en jeu une seule photolithographie. Entièrement auto-aligné, il permet, en s'affranchissant des contraintes dues aux machines d'alignement de masques, de réaliser à faible coût des dispositifs dont les dimensions sont largement sub-microniques.

## Revendications

1. Procédé de réalisation d'un transistor bipolaire à hétérojonction par empilement de couches semi-conductrices épitaxiées, comprenant les étapes consistant à épitaxier à partir d'un support
- au moins une couche de collecteur, respectivement d'émetteur,
- au moins une couche de base ne présentant pas une rigidité suffisante pour s'auto-porter, et
- au moins une couche d'émetteur, respectivement de collecteur,
lesdites couches ayant des compositions entraînant un défaut d'accord de maille à l'origine de déformations, et
l'étape consistant à épitaxier ladite couche de collecteur, respectivement d'émetteur, comprenant les sous-étapes consistant à épitaxier au contact de ladite couche de base
- au moins une première sous-couche (C1) d'équilibre des contraintes et de réduction desdites déformations, et
- au moins une deuxième sous-couche (C2) du côté opposé à ladite couche de base par, rapport à ladite première sous- couche,
le procédé comprenant en outre des étapes consistant à :
- graver les couches supérieures à ladite couche d'émetteur, respectivement de collecteur ; et
- graver ladite couche d'émetteur, respectivement de collecteur,
et le procédé comprenant en outre des étapes consistant à :
- réaliser une sous-gravure profonde de ladite deuxième sous-couche (C2) pour réduire la capacité base-collecteur;
- remplir d'un matériau isolant l'espace dégagé par ladite sous-gravure entre ladite première sous-couche de collecteur, respectivement d'émetteur, et la couche située en dessous de la deuxième sous-couche.

2. Transistor bipolaire à hétérojonction comprenant un support et, épitaxiées, à partir de ce support, au moins :
- une couche de collecteur, respectivement d'émetteur ;
- au moins une couche de base (B) ne présentant pas une rigidité suffisante pour s'auto-porter; et
- au moins une couche d'émetteur, respectivement de collecteur ;
lesdites couches ayant des compositions entraînant un défaut d'accord de maille à l'origine de déformations,
ladite couche de collecteur, respectivement d'émetteur, comprenant :
- au moins une première sous-couche (C1) au contact de ladite couche de base, d'équilibre des contraintes et de réduction desdites déformations ; et
- au moins une deuxième sous-couche (C2) du côté opposé à ladite couche de base par rapport à ladite première sous-couche,
les couches supérieures à ladite couche d'émetteur, respectivement de collecteur, étant gravées,
est **caractérisé en ce que**
ladite deuxième sous-couche (C2) présente une sous-gravure profonde,
et **en ce que** le transistor comprend en outre
un matériau emplissant l'espace dégagé par ladite sous-gravure, ledit matériau présentant à la fois une viscosité suffisamment faible pour emplir la sous-gravure, une bonne adhérence aux surfaces semiconductrices des sous-couches adjacentes et la possibilité d'être durci une fois en place.

3. Transistor selon la revendication 2, dans lequel ladite une première sous-couche (C1) est sensiblement de même composition que ladite couche d'émetteur respectivement de collecteur.

4. Transistor selon l'une quelconque des revendications 2 et 3, dans lequel ladite deuxième sous-couche est sous-gravée à une extension latérale minimale comprise entre celle de la base et celle de la jonction émetteur-base, respectivement collecteur-base.

5. Transistor selon l'une quelconque des revendications 2 à 4, dans lequel ladite couche d'émetteur, respectivement de collecteur, comprend :
- au moins une première sous-couche (E1) au contact de ladite couche de base, sensiblement de ladite composition ; et
- au moins une deuxième sous-couche (E2) du côté opposé à ladite couche de base par rapport à ladite première sous-couche.

6. Transistor selon l'une quelconque des revendications 2 à 5, dans lequel :
- ladite couche de base est en GaAsSb ;
- lesdites premières sous-couches sont en InGaAIAs ; et
- lesdites deuxièmes sous-couches sont en InP.

7. Transistor selon l'une quelconque des revendications 2 à 6, dans lequel ledit matériau emplissant l'espace dégagé par ladite sous-gravure est une résine photosensible, du polyimide ou du BCB.

8. Transistor selon la revendication 7, dans lequel la couche de base étant composé de GaAsSb comprend un taux d'antimoine inférieur à 50%.

9. Transistor selon l'une quelconque des revendications 2 à 8, dans lequel la couche de basé (B) présente une épaisseur comprise entre 20 et 50 nm et une longueur de 1,5 à 2 µm.

10. Transistor selon l'une quelconque des revendications 2 à 9 dont la fréquence est supérieure à 500 GHz.

## Patentansprüche

1. Verfahren zum Herstellen eines Bipolartransistors mit Heteroübergang durch Stapeln von epitaxierten Halbleiterschichten, die Schritte umfassend, die darin bestehen, aus einem Träger folgendes zu epitaxieren
- zumindest eine Kollektorschicht, beziehungsweise Emitterschicht,
- zumindest eine Basisschicht, die eine unzureichende Steifigkeit aufweist, um sich selbst zu tragen, und
- zumindest eine Emitterschicht, beziehungsweise Kollektorschicht,
wobei die besagten Schichten Zusammensetzungen aufweisen, die zu einem Gitteranpassungsfehler führen, der Verformungen hervorruft, und
der Schritt, der darin besteht, die besagte Kollektorschicht, beziehungsweise Emitterschicht zu epitaxieren, die Unterschritte umfasst, die darin bestehen, in Kontakt mit der Basisschicht, folgendes zu epitaxieren
- zumindest eine erste Unterschicht (C1) zum Ausgleichen der Spannungen und zum Verringern der besagten Verformungen, und
- zumindest eine zweite Unterschicht (C2) auf der Seite gegenüber der Basisschicht im Verhältnis zur besagten ersten Unterschicht,
wobei das Verfahren darüber hinaus die folgenden Schritte umfasst:
- Gravieren der Schichten oberhalb der besagten Emitterschicht, beziehungsweise Kollektorschicht; und
- Gravieren der besagten Emitterschicht, beziehungsweise Kollektorschicht,
und das Verfahren darüber hinaus die folgenden Schritte umfasst:
- Erzeugen einer tiefen Untergravur der besagten zweiten Unterschicht (C2) zum Verringern der Kollektor-Basis-Kapazität;
- Auffüllen mit einem Isoliermaterial des von der besagten Untergravur erzeugten Freiraums zwischen der besagten ersten Kollektor-, beziehungsweise Emitter-Unterschicht und der Schicht, die sich unter der zweiten Unterschicht befindet.

2. Bipolartransistor mit Heteroübergang, der einen Träger, und ausgehend von diesem Träger epitaxiert zumindest folgendes umfasst:
- eine Kollektorschicht, beziehungsweise Emitterschicht;
- zumindest eine Basisschicht (B), die eine unzureichende Steifigkeit aufweist, um sich selbst zu tragen; und
- zumindest eine Emitterschicht, beziehungsweise Kollektorschicht;
wobei die besagten Schichten Zusammensetzungen aufweisen, die zu einem Gitteranpassungsfehler führen, der Verformungen hervorruft,
wobei die besagte Kollektorschicht, beziehungsweise Emitterschicht folgendes umfasst:
- zumindest eine erste Unterschicht (C1) in Kontakt mit der besagten Basisschicht, zum Ausgleichen der Spannungen und zum Verringern der besagten Verformungen; und
- zumindest eine zweite Unterschicht (C2) auf der Seite gegenüber der besagten Basisschicht im Verhältnis zur besagten ersten Unterschicht,
wobei die Schichten oberhalb der besagten Emitterschicht, beziehungsweise Kollektorschicht graviert werden,
**dadurch gekennzeichnet, dass**
die besagte zweite Unterschicht (C2) eine tiefe Untergravur aufweist,
und dadurch, dass der Transistor darüber hinaus folgendes umfasst
ein Material zum Auffüllen des von der besagten Untergravur erzeugten Freiraums, wobei das besagte Material sowohl eine ausreichend geringe Viskosität aufweist, um die Untergravur aufzufüllen, als auch eine gute Haftung auf den Halbleiterflächen der angrenzenden Unterschichten, und die Möglichkeit, nach dem Anbringen ausgehärtet zu werden.

3. Transistor nach Anspruch 2, wobei die besagte erste Unterschicht (C1) im Wesentlichen dieselbe Zusammensetzung aufweist, wie die besagte Emitterschicht, beziehungsweise Kollektorschicht.

4. Transistor nach einem der Ansprüche 2 und 3, wobei die besagte zweite Unterschicht auf eine seitliche Mindestausdehnung untergraviert wird, die zwischen jener der Basis und jener der Emitter-Basis-Verbindung, beziehungsweise Kollektor-Basis-Verbindung enthalten ist.

5. Transistor nach einem der Ansprüche 2 bis 4, wobei die besagte Emitterschicht, beziehungsweise Kollektorschicht folgendes umfasst:
- zumindest eine erste Unterschicht (E1) in Kontakt mit der besagten Basisschicht, im Wesentlichen mit derselben Zusammensetzung; und
- zumindest eine zweite Unterschicht (E2) auf der Seite gegenüber der besagten Basisschicht im Verhältnis zur besagten ersten Unterschicht.

6. Transistor nach einem der Ansprüche 2 bis 5, wobei:
- die besagte Basisschicht aus GaAsSb besteht;
- die besagten ersten Unterschichten aus InGaAlAs bestehen; und
- die besagten zweiten Unterschichten aus InP bestehen.

7. Transistor nach einem der Ansprüche 2 bis 6, wobei das besagte Material zum Auffüllen des von der besagten Untergravur erzeugten Freiraums ein lichtempfindliches Harz, Polyimid oder BCB ist.

8. Transistor nach Anspruch 7, wobei die Basisschicht, die sich aus GaAsSb zusammensetzt, einen Antimonanteil von weniger als 50% umfasst.

9. Transistor nach einem der Ansprüche 2 bis 8, wobei die Basisschicht (B) eine Stärke zwischen 20 und 50 nm und eine Länge von 1,5 bis 2 µm aufweist.

10. Transistor nach einem der Ansprüche 2 bis 9, dessen Frequenz höher als 500 GHz ist.

## Claims

1. Method for producing a heterojunction bipolar transistor by stacking epitaxed semiconductor layers, comprising the steps consisting of epitaxing, from a support,
- at least one collector or respectively emitter layer,
- at least one base layer not having sufficient rigidity to be self-supporting, and
- at least one emitter or respectively collector layer,
said layers having compositions causing a defect in mesh agreement giving rise to deformations, and
the step consisting of epitaxing said collector or respectively emitter layer comprising the substeps consisting of epitaxing, in contact with said base layer,
- at least one first sub-layer (C1) for balancing stresses and reducing said deformations, and
- at least one second sub-layer (C2) on the side opposite to said base layer with respect to said first sub-layer,
the method further comprising steps consisting of:
- etching the layers higher than said emitter or respectively collector layer; and
- etching said emitter or respectively collector layer,
and the method further comprising steps consisting of:
- carrying out deep sub-etching of said second sub-layer (C2) in order to reduce the base-collector capacitance;
- filling, with an insulating material, the space left free by said sub-etching between said first collector or respectively emitter sub-layer and the layer situated below the second sub-layer.

2. Heterojunction bipolar transistor comprising a support and, epitaxed from this support,
- at least one collector or respectively emitter layer,
- at least one base layer (B) not having sufficient rigidity to be self-supporting, and
- at least one emitter or respectively collector layer;
said layers having compositions causing a defect in mesh agreement giving rise to deformations,
said collector or respectively emitter layer comprising:
- at least one first sub-layer (C1) in contact with said base layer, for balancing stresses and reducing said deformations; and
- at least one second sub-layer (C2) on the side opposite to said base layer with respect to said first sub-layer,
the layers higher than said emitter or respectively collector layer being etched,
is **characterised in that**
said second sub-layer (C2) has deep sub-etching, and **in that** the transistor further comprises a material filling in the space left clear by said sub-etching, said material having sufficiently low viscosity to fill the sub-etching, good adhesion to the semiconductor surfaces of the adjacent sub-layers and the possibility of being hardened once in place.

3. Transistor according to claim 2, in which said one first sub-layer (C1) is substantially of the same composition as said emitter or respectively collector layer.

4. Transistor according to either one of claims 2 and 3, in which said second sub-layer is sub-etched to a minimum lateral extension lying between that of the base and that of the emitter-base or respectively collector-base junction.

5. Transistor according to any one of claims 2 to 4, in which said emitter or respectively collector layer comprises:
- at least one first sub-layer (E1) in contact with said base layer, substantially of said composition; and
- at least one second sub-layer (E2) on the side opposite to said base layer with respect to said first sub-layer.

6. Transistor according to any one of claims 2 to 5, in which:
- said base layer is made from GaAsSb;
- said first sub-layers are made from InGaAlAs; and
- said second sub-layers are made from InP.

7. Transistor according to any one of claims 2 to 6, in which said material filling in the space left free by said sub-etching is a photosensitive resin, **a** polyimide or BCB.

8. Transistor according to claim 7, in which the base layer, being composed of GaAsSb, comprises a proportion of antimony of less than 50%.

9. Transistor according any one of claims 2 to 8, in which the base layer (B) has a thickness of between 20 and 50 nm and a length of 1.5 to 2 µm.

10. Transistor according to any one of claims 2 to 9, the frequency of which is higher than 500 GHz.
